Europäisches Patentamt

(19) European Patent Office

Office européen des brevets

(11) EP 0 915 524 A1

(12) EUROPEAN PATENT APPLICATION

(43) Date of publication:
12.05.1999 Bulletin 1999/19

(51) Int. Cl.$^6$: H01L 41/107

(21) Application number: 97308437.9

(22) Date of filing: 23.10.1997

(84) Designated Contracting States:
AT BE CH DE DK ES FI FR GB GR IE IT LI LU MC NL PT SE
Designated Extension States:
AL LT LV RO SI

(71) Applicant: NGK INSULATORS, LTD.
Nagoya City Aichi Pref. (JP)

(72) Inventor: Ishida, Yoshihiko
Nagoya City, Aichi Pref. (JP)

(74) Representative:
Paget, Hugh Charles Edward et al
MEWBURN ELLIS
York House
23 Kingsway
London WC2B 6HP (GB)

(54) **Piezoelectric devices**

(57) A piezoelectric device useful as an electrical transformer or filter has a vibratable element (1) having at least two members (2) arranged for bending oscillation. Each member (2) carries a piezoelectric driving element (4) and at least one member (2) carries a piezoelectric output element (5). Operation of the driving elements (4) by a voltage causing transversal or longitudinal deformation of the piezoelectric layer induces bending oscillation of the members (2). The output element (5) has a piezoelectric layer polarized in its thickness direction and a pair of electrodes generating electrical output upon transversal deformation of its piezoelectric layer. The driving elements (4) stimulate a predetermined vibrational bending mode of the vibratable element. In an alternative embodiment the driving elements stimulate simultaneously two vibrational bending modes of the element having mutually perpendicular bending directions.

Fig 1

## Description

This invention relates to piezoelectric devices, particularly devices employing electromechanical coupling which can be used as electrical transformers, or as electrical filters.

Piezoelectric transformers have advantages of small size and high efficiency. By means of electrodes on the surfaces of a piezoelectric material body, electrical power is converted into mechanical vibration which is re-converted into transformed electrical power. Power converters operating at high frequencies (MHz range) are described in Japanese Journal of Applied Physics, Vol. 33 (1994), pages 2953 to 2956. Generally, a piezoelectric transformer has high performance only at its resonant frequency.

To obtain a low resonant frequency, it has been proposed to use a flexural vibration mode of a suitable elastic body. The flexural vibration is stimulated by an input piezoelectric transducer, and power is taken out by an output piezoelectric transducer. Such devices are described in JP-A-56-134787, where the flexible members are a U-shaped member similar to a tuning fork and an S-shaped member. The frequency range of the device is said to be from several 100's Hz to several 10's KHz. In these devices, the piezoelectric input transducer operates by the transversal effect, i.e. the piezoelectric member is a thin layer between electrodes on its major faces, and is polarized in its thickness direction, so that application of voltage across the electrodes causes a length change in the direction parallel to the electrodes. This input transducer is bonded to the vibratable metal member. To obtain output, there is employed a high impedance piezoelectric oscillator employing the longitudinal effect. A layer of piezoelectric material is bonded to the vibratable metal member and has electrodes at opposite ends. The layer is longitudinally polarized. The longitudinal deformation of the piezoelectric layer provides the electrical output at the electrodes. In each device shown there is a single input transducer and a single output transducer. The input transducer effects the driving of the device.

Improvement of such devices employing a flexural vibration can take place in several ways. There is a need for a lower resonant frequency, particularly at power grid frequencies (50 Hz or 60 Hz). Increase of efficiency is desirable, and also a wider frequency band pass; for example if the device is nominally resonant at 50 Hz being the grid frequency, there should be a frequency range of resonance in case the grid frequency varies from 50 Hz.

The present invention seeks to provide improvements of this kind.

According to the present invention in one aspect there is provided a piezoelectric device comprising a vibratable element having at least two members made of elastic material and arranged for bending oscillation, each said member having mounted on it a piezoelectric driving element and at least one of said members having mounted on it a piezoelectric output element, each said driving element having a piezoelectric layer and a pair of electrodes arranged so that on application of a driving voltage transversal or longitudinal deformation of the piezoelectric layer takes place to induce bending oscillation of the member on which the element is mounted, characterized in that said output element has a piezoelectric layer polarized in its thickness direction and a pair of electrodes arranged to generate electrical output upon transversal deformation of its piezoelectric layer, and said driving elements are arranged to stimulate a predetermined vibrational bending mode of said vibratable element. Preferably, said driving elements are arranged to stimulate substantially only a primary vibrational bending mode of said vibratable element.

Whereas the devices of the prior art are intended to provide a high output voltage, and in particular to provide a considerable step-up voltage, the devices of the present invention permit adjustment of output impedance, selection of a desired filter effect, and increase of efficiency. The piezoelectric device of the invention may be used as a transformer, for example stepping-down a grid-frequency voltage from for example 100 V to 30 V.

In the invention as set out above, the output element has a piezoelectric layer polarized in its thickness direction, operating with the transversal effect. This enables the selection and adjustment of the output impedance and also the output voltage.

A second important feature is the use of at least one driving element on each of two flexible members of the vibratable element. The driving elements are preferably arranged to stimulate substantially only the primary vibrational bending mode of the vibratable element. This may be achieved by example by connecting the driving elements in parallel, but other arrangements are possible.

When the primary (lowest frequency) bending mode is stimulated, the size of the device can be minimized. However, it may in some embodiments be desirable to stimulate a higher order harmonic mode. Suitably only the predetermined mode is stimulated. Stimulation of only the predetermined vibrational mode increases efficiency by suppressing unwanted vibrations, and can eliminate unwanted signals, for example voltage surges.

In another aspect, the invention provides a piezoelectric device comprising a vibratable element having at least two members made of elastic material and arranged for bending oscillation, said members having mounted on them at least two piezoelectric driving elements and at least one piezoelectric output element, each said driving element having a piezoelectric layer and a pair of electrodes arranged so that on application of a driving voltage transversal or longitudinal deformation of the piezoelectric layer takes place to induce bending oscillation of the member on which the element is mounted, characterized in that said output element has a piezoelectric layer polarized in its thickness direction and a pair of electrodes arranged to generate electrical output upon transversal deformation of its piezoelectric layer, and in that said driving elements are arranged to stimulate simultaneously two vibrational bending modes of said vibratable element having mutually perpendicular bending directions.

The device of the invention in this aspect is intended to provide a relatively wide band pass, i.e. range of operational resonant frequency, which is particularly useful if the frequency of the input power is variable, for example in the case of a grid frequency. The two different bending modes having mutually perpendicular vibration directions can be appropriate selected relative to each other with different frequencies so as to provide this range of resonant frequency. Nevertheless, high efficiency can preferably be obtained as in the first aspect of the invention, by the employment of a plurality of driving elements to stimulate in principle only the desired vibrational modes, and suppress other unwanted vibrations.

Preferably each of the oscillatable members of the element has a piezoelectric output element mounted on it.

The use of a plurality of output elements can provide wide frequency band width, and good frequency response.

In this aspect also the feature of transversal effects in the output elements is employed, with thickness direction polarisation of the output piezoelectric layers. This enables easy selection of an appropriate output impedance.

In the devices of the invention, to increase output capacitance, and thereby reduce output impedance, preferably the output element has a plurality of layers of piezoelectric material each sandwiched between a pair of electrodes, the transversal polarisation directions of each adjacent pair of said layers being mutually opposite.

The driving elements in the devices of the invention are preferably of the transversal effect type, and may have a single layer of piezoelectric material, or a plurality of such layers. A multi-layer element enlarges the dumping capacitance associated with the electrode area.

The vibratable element can be of any suitable material and of any suitable shape. Preferably it is of the nature of a tuning fork, having at least two members in the form of elongate arms which extend to a free end, with the electrodes of the driving elements on them being elongate with the direction of elongation parallel to the elongation direction of the respective members. The thickness of the member may change along its length, in order to provide desired vibrational frequencies, particularly in the case of the second aspect of the invention where two different bending modes having mutually perpendicular vibration directions are desired. Suitable materials are elinvar alloy and quartz, which both have an elastic modulus which is relatively non-variant with temperature, and have good mechanical quality factors. This is advantageous if the device is to be used in a range of temperatures. The mechanical inductance of the vibrating element governs the total behaviour of the transformer, and therefore the use of a suitable material for the vibratable element can compensate for temperature variation of the elasticity of the piezoelectric elements.

Where it is electrically conductive, the vibratable element can form one electrode of an input or output element of the device.

The invention is particularly applicable to devices in which the output voltage is the same as, similar to or lower than the input voltage, but is not limited to such devices.

As well as for power conversion (transformation), the devices of the invention can be used also as filters.

Embodiments of the invention will now be described by way of non-limitative example, with reference to the accompanying drawings in which:-

Fig. 1 is a diagrammatic side view of a first piezoelectric transformer embodying the invention;
Fig. 2 is a diagram illustrating the vibration of the device of Fig. 1;
Fig. 3 is a diagrammatic illustration of a multi-layer piezoelectric output element used in the embodiments illustrated;
Fig. 4 is a graph illustrating variation of voltage against time in the device of Fig. 1;
Fig. 5 is a diagrammatic perspective view of a second piezoelectric transformer embodying the invention;
Fig. 6 is a diagram illustrating the vibrational mode of the device of Fig. 5;
Fig. 7 is a perspective view of a third piezoelectric transformer embodying the invention;
Fig. 8 is a diagram illustrating the vibrational mode of the device of Fig. 7;
Fig. 9 is a perspective view of another piezoelectric transformer having two stimulated vibrational modes, embodying the invention;
Fig. 10 is an end view of the device of Fig. 9 illustrating the electrode connections and the vibrational modes;
Fig. 11 is a view similar to that of Fig. 10 illustrating a variation of the device of Fig. 10;
Fig. 12 is a view similar to that of Fig. 10 of another device which is a modification of that of Fig. 10;
Fig. 13 is a graph showing insertion loss against frequency for a device of the type shown in Figs. 9 to 12;
Fig. 14 is a perspective view of another modified version of the device of Fig. 9;

Fig. 15 is a perspective view of yet another modified version of the device of Fig. 9;

Fig. 16 shows a further device which is a modification of that of Fig. 9;

Fig. 17 is a perspective view of a device of the invention illustrating a driving element of longitudinal effect type; and

Fig. 18 illustrates the deformed shape of the driving element of Fig. 17.

In the different embodiments, the same reference numerals are used to designate the same or similar parts, and the description of such parts is not repeated for each embodiment.

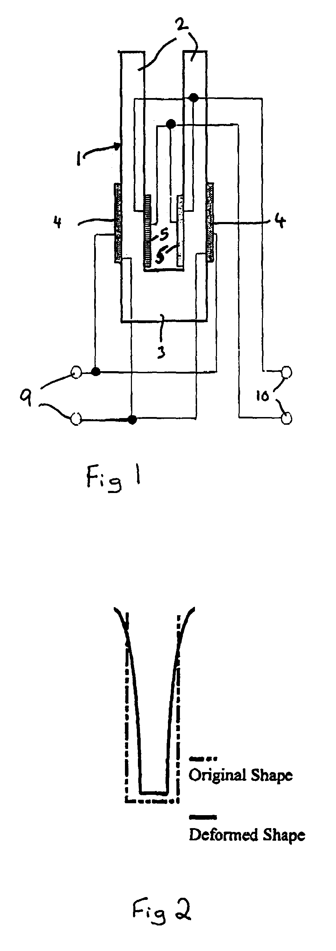

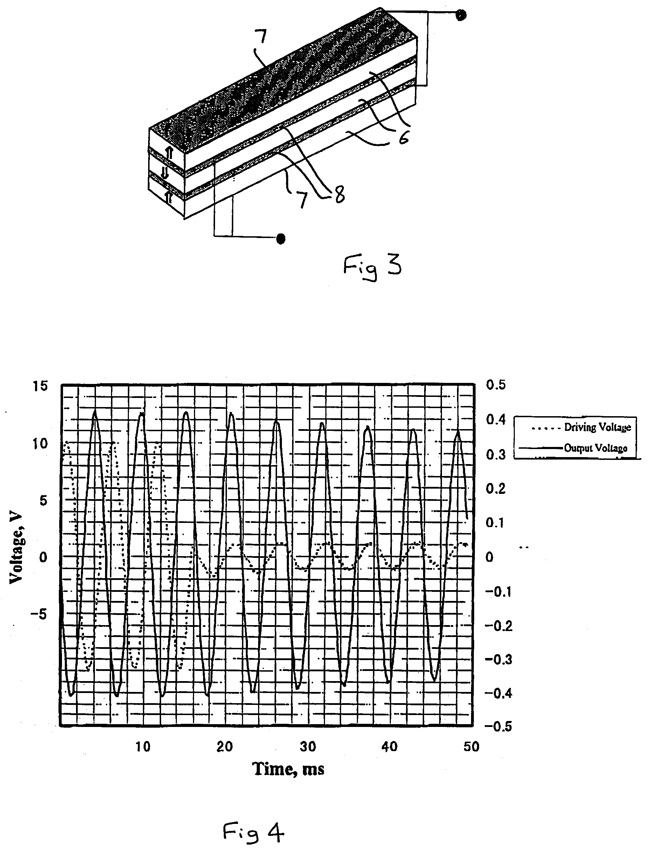

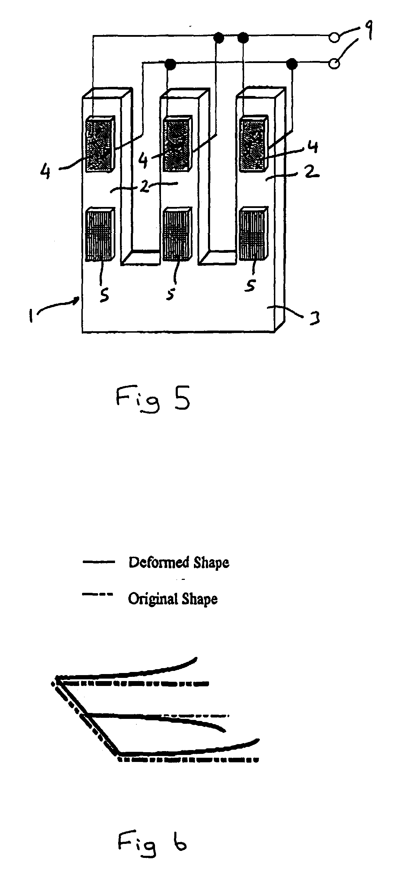

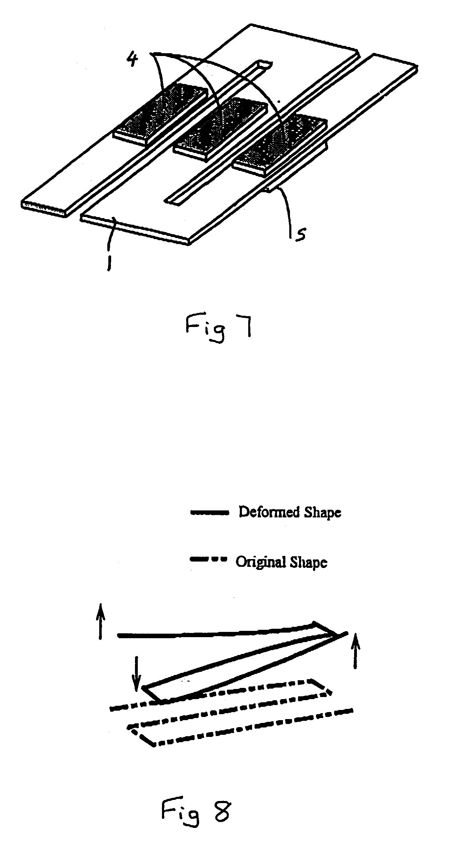

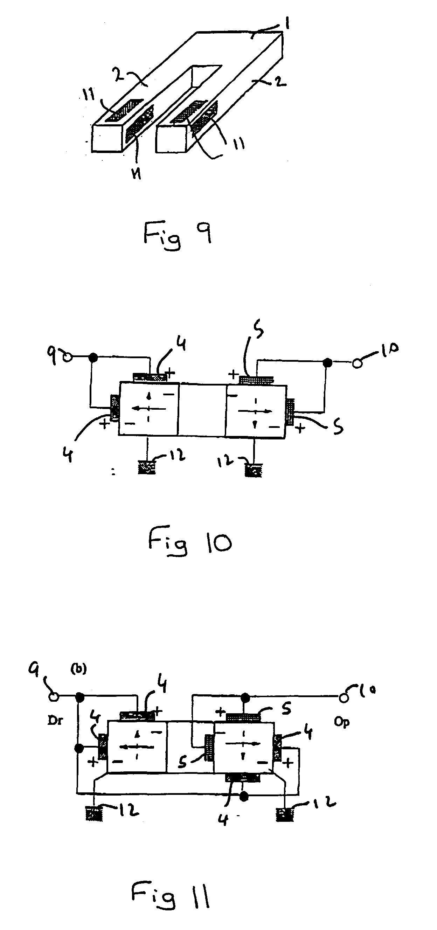

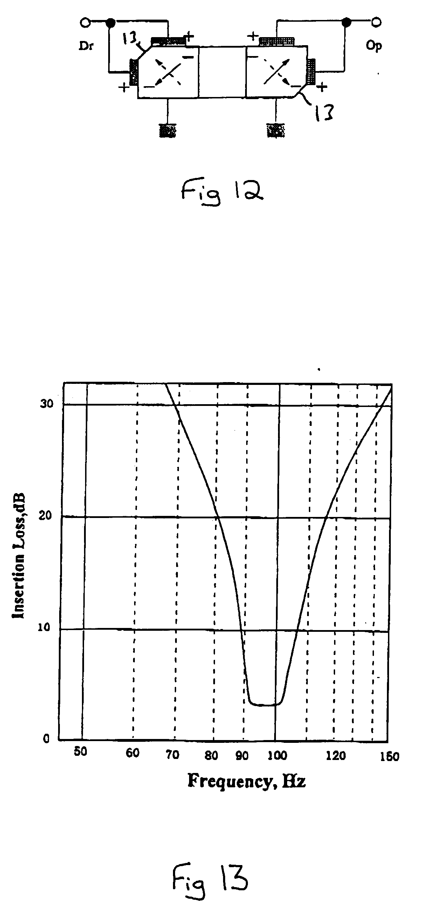

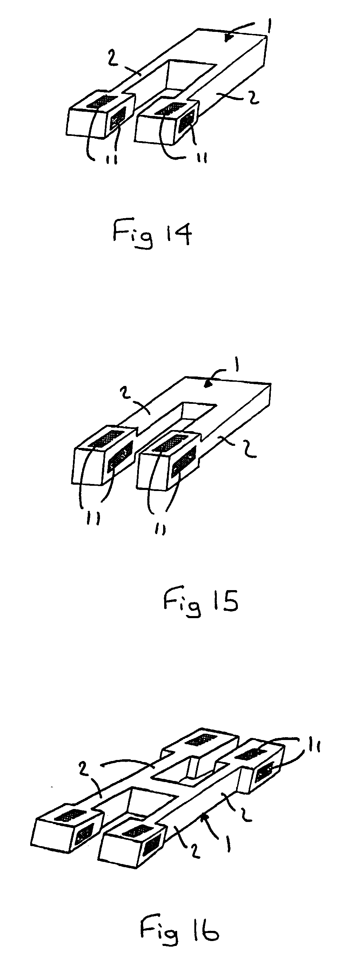

The piezoelectric transformer of the invention shown in Fig. 1 has a metal vibratable element 1 of tuning fork shape, having two vibratable arms 2 with free ends and a base 3 representing a vibrational nodal region by which the element 1 may be fixedly held. The element 1 is made of elinvar metal which has an elastic modulus which is stable against temperature and has low mechanical loss. An alternative material is quartz, which improves temperature stability.

Each of the vibratable arms 2 has a piezoelectric driving element 4 and a piezoelectric output element 5 mounted on it near its junction with the base 3. The output elements 5 are mounted on the inner opposed faces of the two arms, and the driving elements 4 on the outer faces of the arms. The driving and output elements 4, 5 are each made of layers of piezoelectric material of PZT (lead-zirconium-titanate) ceramics, having the multi-layer structure shown in Fig. 3, which shows three layers 6 of piezoelectric ceramic material and two surface electrodes 7 and two internal electrodes 8. The number of layers 6 may be more or less than three. The polarisation direction of the piezoelectric layers 6 are indicated by arrows in Fig. 3, and it can be seen that all layers are polarized in the thickness direction and that each adjacent pair of layers 6 has opposite polarisation direction. Thus all the input and output elements operate by the transversal effect.

As an alternative to PZT ceramics, another piezoelectric material such as a lithium niobate single crystal may be employed. Lithium niobate single crystal has some advantages of improved mechanical quality factor and little or no degradation of polarisation at higher operating temperatures. Mechanical quality factor is the inverse of the dielectric loss: $\tan \delta$, which can be measured as the phase angle discrepancy between voltage wave and current wave.

The piezoelectric elements 4,5 may be bonded to the vibratable arms 2 in any suitable manner. Three examples may be given:

(1) The surfaces of the element and of the arm are bonded by means of a reactive metal thin film made of Ag-Cu-In-Ni alloy using heat treatment.
(2) A silver paste electrode is formed on both the element and the arm. These surfaces are then bonded by a lead-silver metal based solder.
(3) Surfaces of the element and the arm are bonded by boron-silicate glass, using heat treatment.

Suitable materials for the electrodes are a silver paste, a palladium paste and a paste of mixed silver and palladium.

As mentioned, when the arm is electrically conductive, it may form an electrode of the piezoelectric element.

Fig. 1 shows the electrode connections. The electrodes of the driving elements 4 are connected in parallel to input terminals 9, and the electrodes of the output elements 5 are likewise connected in parallel to output terminals 10. Application of a voltage, for example a single frequency sinusoidal voltage of a selected frequency, at the input electrodes 9 activates the lowest resonant frequency primary vibrational mode of the element 1, shown in Fig. 2, where the broken line indicates the original non-stressed shape, and the solid line the deformed state in vibration. The positive driving of both arms 2 simultaneously by the driving elements 4 is effective to activate substantially only the desired primary vibrational mode and substantially to suppress other spurious vibration modes. The output elements 5 are also connected in parallel so that their respective electrical outputs due to the primary vibrational mode are summed at the output terminals 10. In one device, a primary resonant frequency of 105 Hz is obtained with a transformer element of 150 mm total length. The mechanical quality factor is better than 20,000. The number of layers 6 of the laminated structure electrode of the output elements 5 determines the output impedance, which can be less than 10 Ω in an example which employed nine layers 6 of PZT, each 0.15 mm thick.

As described above, due to the large mechanical inductance of the vibratable element 1, the device can suppress or filter out frequencies other than the resonant frequency. Furthermore, in a modification in which each driving element operates with the longitudinal effect, with electrodes at both longitudinal ends of the piezoelectric layer, the device can also withstand high voltage peak impulses, for example a 15 kV peak impulse input voltage, without insulation breakdown. In such a case the driving element preferably has a single piezoelectric layer e.g. of thickness 2 mm or greater.

Because of the large mechanical inductance of the vibrating element 1, the output voltage is persistent, after the input voltage is shut down, as shown in Fig. 4 where the output voltage is represented by the full line and the input driving voltage by the dotted line.

The collaborative activation by the multiple driving elements 4 of a specific vibrational mode provides a fixed point (node) at the root of the arms which can be used for support of the device while minimizing mechanical loss.

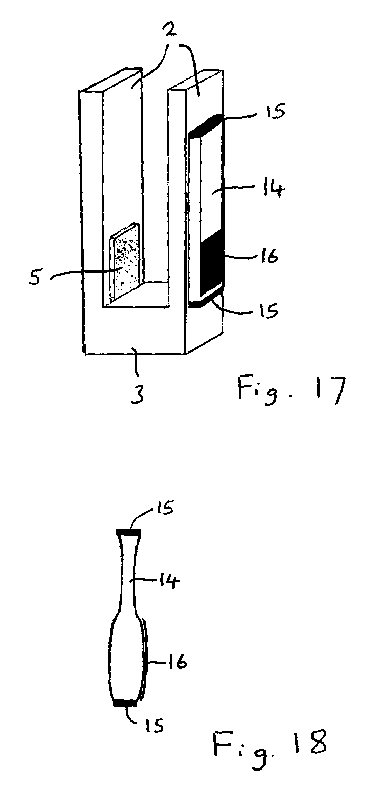

Fig. 5 shows another embodiment, having features similar to that of Fig. 1, which will not be described again, but differing in that the vibrating element 1 is of a plate-like shape having three vibrating arms 2 extending from its base 3 to free ends. The arms 2 vibrate perpendicularly to the plane of the element 1. Each arm 2 carries a driving element 4 and an output element 5, which are as described in relation to Fig. 1. In this case the driving and output elements 4, 5 are all arranged on one face of the plate-like element 1, with the output elements close to the junction of the arms 2 with the base 3 and the driving elements close to the free ends of the arms 2. In Fig. 5 the parallel connection of the driving elements is shown, but the similar parallel connection of the output elements 5 is not shown, for clarity. The electrodes of the driving and output elements 4, 5 on the central one of the arms 2 are connected inversely, relative to the electrodes of the elements 4, 5 on the outer two arms 2. Consequently, the primary vibrational mode stimulated on application of driving voltage at the electrodes 9 is as shown in Fig. 6. As in the case of Fig. 1, the stimulation of this primary voltage by the driving elements reduces spurious mode vibrations to a very great extent. This shape has the advantage of a node near the route of the central blade, which can be used for fixing, and reduces mechanical loss. As in Fig. 1, the combined outputs of the output elements 5 appear as a sum at the output terminals 10.

Fig. 7 shows another piezoelectric transformer embodying the invention, in which the vibratable body 1 has a folded bar shape, having an S-shape with three parallel arms, the outer two arms being free at one end each. This element 1 can be made for example of quartz crystal, which has a high mechanical quality factor. On one side, each arm carries a driving element 4 and on its other side, opposed to the driving element 4, an output element 5. These elements are as described in previous embodiments. The driving element and output elements on the centre bar of the element 1 are inversely connected, relative to the driving output elements on the outer arms, so that the primary bending mode shown in Fig. 8 is activated. With an element 1 made of quartz, the overall mechanical quality factor can be over 100,000. An operating frequency of 60 Hz has been achieved with this configuration.

Particular advantages with the devices of Figs. 1 to 8 are firstly that a low resonant frequency can be obtained, using the appropriate bending vibration mode of the vibratable element 1. The resonant frequency may even be as low as mains frequency of 50 Hz or 60 Hz, with an element of reasonably small size. Secondly, the input and output impedance can be low, since the transverse effect type of piezoelectric elements, particularly elements with plural thin layers sandwiched between parallel electrodes, and transverse polarisation, has inherently a low equivalent impedance, because of the large dumping capacitance, compared with the longitudinal effect elements used in the prior art. This particularly applies on the output side where there are a plurality of output elements operating cooperatively, as in the embodiments shown. The stability of the resonant frequency against temperature deviation can be high, using appropriate materials as discussed above. These materials can also enable the driving elements to have a very high electric breakdown voltage, and the large mechanical inductance of the device as a whole inhibits the passing of a high voltage surge, such as a lightning impulse. The device can furthermore accurately filter the desired input frequency. Because of the plurality of driving elements, which collaborate to stimulate only the primary frequency, higher order vibration modes having frequencies close to that of the primary mode are reduced and minimised.

Fig. 9 shows a further embodiment of the invention, which is of the tuning fork type shown in Fig. 1 and which has driving and output piezoelectric elements here all designated by the reference numeral 11, since whether each of these is an output element or a driving element depends upon the electrical connections. The arms 2 in this case have an approximately square cross-sectional shape. As Fig. 9 shows, the elements 11 are arranged on two mutually perpendicular faces of the arms 2 and can be on three or even four of the faces of the arms, as discussed below. Fig. 10 shows a first arrangement of this device, in which two mutually perpendicular vibrational modes are stimulated by the driving voltage. One of the arms 2 (left-hand arm in Fig. 10) has two driving elements 4 on respectively two mutually perpendicular faces, the electrodes of which are connected to an input terminal 9, the other terminal being provided by the element 1 itself, as illustrated by the earth or return connection 12. The driving elements 4 are connected to the terminal 9 in parallel, so that the application of a suitable sinusoidal or other varying voltage stimulates two mutually perpendicular vibrational modes illustrated by the solid line and broken line arrows.

On the second arm 2 are two output elements 5 on two adjacent mutually perpendicular faces, connected in parallel to the output terminal 10, the other electrical connection being again to the earth or return connection 12. The output elements 5 generate signals from the two vibrational modes, and these signals are combined at the output terminal 10. The materials of the body 1 and the elements 4, 5 may be the same as in the embodiments of Figs. 1 to 8, described above, but in this case the element 1 must be electrically conductive.

Fig. 11 shows a modification of the device of Fig. 10, in which both the arms 2 have two driving elements 4 on mutually perpendicular faces. The right hand arm only also has output elements 5 on two mutually perpendicular faces. The driving elements 4 stimulating the vertical vibrations (indicated by the broken arrows) are on an upper face of the left-hand arm and the lower face of the right-hand arm, and the driving elements 4 stimulating the horizontal vibrational mode are on the outer faces of the two arms 2 respectively. Thus in this embodiment there is collaborative driving of the two arms 2 by the driving elements 4, as in the embodiment of Fig. 1.

Fig. 12 shows two mutually perpendicular vibrations indicated by arrows which are at 45° to the general plane of the device. Electrode connections are as in Fig. 10, but one corner of each arm has a chamfer 13 which has the effect of stimulating these oblique vibrational modes. The chamfer 13 on the left-hand arm is at its upper outer side and the chamfer at the right-hand arm is on the lower outer side.

The devices of Figs. 9 to 12 each have two mutually perpendicular vibrations stimulated by the driving elements 4. By choice of the shape of the element 1, the resonant frequencies of these two vibrational modes can be selected so as to be close, for example within 10% of each other, so that a relatively wide frequency pass band can be obtained, as illustrated in Fig. 13. In this case a central primary resonant frequency of 96 Hz is obtained, with a transformer element of 150 mm total length, made of elinvar metal.

The devices of Figs. 9 to 12 can have their frequencies adapted in various ways. It is possible to thicken the arms at their end portions, to adjust the frequency or to reduce the operating frequency, either in the plane of the device as shown in Fig. 14 or in a plane perpendicular to the general plane of the device as shown in Fig. 15.

The device of Fig. 16 is a variation in which the element 1 is of H-shape, having four vibratable arms 2. Its principle of operation is the same as that of the devices of Figs. 9 to 15.

Other advantages obtainable with the devices of Figs. 9 to 16 are as described above with relation to Figs. 1 to 8.

As already indicated, in these embodiments, all of the output piezoelectric elements are of the multi-layer type shown in Fig. 3, but in appropriate cases, single layer elements may be used, particularly for the driving elements.

One area of application of this invention is as a step-down transformer from a power distribution line (grid line) utilizing grid frequency. In this case, the input frequency is fixed. The frequency to be adjusted is the resonant frequency of the device. The designed resonant frequency is determined based on the elastic properties of the materials and the shape. The actual resonant frequency, however, may need to be adjusted to the input signal frequency because of the machining error and discrepancy between the actual and reported material properties. A practical method is to cut the end portion of the arm by machining to adjust the measured resonant frequency to the target frequency.

For impedance matching an external electrical inductance may be added in series or parallel with the output elements and an external capacitance can be added in parallel with the output elements.

As mentioned, in the invention the piezoelectric driving elements may be of the transversal effect or longitudinal effect type. The longitudinal effect type is illustrated by Figs. 17 and 18. Fig. 17 shows for simplicity only one driving element having a piezoelectric material layer 14 with driving electrodes 15 at each longitudinal end in the direction of the arm of the vibratable element. On one face of the layer 14 is a neutral electrode 16. The deformed shape of the driving element is illustrated in side view by Fig. 18. Fig. 17 also shows one output element 5 which is the same as in the embodiment of Fig. 1. A driving element and output element may be provided on each arm 2, as in Fig. 1.

## Claims

1. A piezoelectric device comprising a vibratable element having at least two members made of elastic material and arranged for bending oscillation, each said member having mounted on it a piezoelectric driving element and at least one of said members having mounted on it a piezoelectric output element, each said driving element having a piezoelectric layer and a pair of electrodes arranged so that on application of a driving voltage transversal or longitudinal deformation of the piezoelectric layer takes place to induce bending oscillation of the member on which the element is mounted, characterized in that said output element has a piezoelectric layer polarized in its thickness direction and a pair of electrodes arranged to generate electrical output upon transversal deformation of its piezoelectric layer, and said driving elements are arranged to stimulate a predetermined vibrational bending mode of said vibratable element.

2. A piezoelectric device according to claim 1 wherein said driving elements are arranged to stimulate substantially only a primary vibrational bending mode of said vibratable element.

3. A piezoelectric device according to claim 1 or 2 having a plurality of said output elements mounted on respective ones of said members, the output elements being electrically connected so that their respective electrical outputs due to said predetermined vibrational bending modes are summed.

4. A piezoelectric device comprising a vibratable element having at least two members made of elastic material and arranged for bending oscillation, said members having mounted on them at least two piezoelectric driving elements and at least one piezoelectric output element, each said driving element having a piezoelectric layer and a pair of electrodes arranged so that on application of a driving voltage transversal or longitudinal deformation of the piezoelectric layer takes place to induce bending oscillation of the member on which the element is mounted, characterized in that said output element has a piezoelectric layer polarized in its thickness direction and a pair of electrodes arranged to generate electrical output upon transversal deformation of its piezoelectric layer, and in that said driving elements are arranged to stimulate simultaneously two vibrational bending modes of said vibratable element having mutually perpendicular bending directions.

5. A piezoelectric device according to claim 4 wherein each said member of said vibratable element has a said piezoelectric output element mounted thereon.

6. A piezoelectric device according to claim 4 or 5 having an even number of said members.

7. A piezoelectric device according to any one of claims 4 to 6 wherein at least one said member has a pair of said driving elements mounted on two mutually perpendicular faces.

8. A piezoelectric device according to any one of claims 4 to 7 wherein said two vibrational bending modes have different frequencies.

9. A piezoelectric device according to claim 8 wherein said different frequencies are sufficiently close that they together create a frequency pass band of the device.

10. A piezoelectric device according to any one of claims 4 to 9 wherein a plurality of said members each have a pair of said driving members mounted on them, said driving elements being arranged to stimulate cooperatively the lowest resonant frequency primary vibrational bending mode of each said member.

11. A piezoelectric device according to any one of claims 1 to 10 wherein each said member is elongate and extends to a free end, and the electrodes of each driving element are elongate with their direction of elongation parallel to the elongation direction of the member.

12. A piezoelectric device according to any one of claims 1 to 11 wherein said output element has a plurality of layers of piezoelectric material each sandwiched between a pair of electrodes, the transversal polarisation directions of each adjacent pair of said layers being mutually opposite.

13. A piezoelectric device according to any one of claims 1 to 12 wherein said vibratable element has a larger mechanical inductance than said driving elements and output elements.

Fig 1

Original Shape

Deformed Shape

Fig 2

Fig 3

Fig 4

Fig 5

—— Deformed Shape

--- Original Shape

Fig 6

Fig 7

Deformed Shape

- - - Original Shape

Fig 8

Fig 9

Fig 10

Fig 11

Fig 12

Fig 13

Fig 14

Fig 15

Fig 16

Fig. 17

Fig. 18

| European Patent Office | EUROPEAN SEARCH REPORT | Application Number EP 97 30 8437 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X,D | PATENT ABSTRACTS OF JAPAN vol. 006, no. 012 (E-091), 23 January 1982 -& JP 56 134787 A (NEC CORP), 21 October 1981, * abstract * | 1-5 | H01L41/107 |
| A | FR 2 506 505 A (THOMSON CSF) * page 2, line 26 – page 6, line 28; figure 1 * | 1 | |

TECHNICAL FIELDS SEARCHED (Int.Cl.6)

H01L

The present search report has been drawn up for all claims

| Place of search | Date of completion of the search | Examiner |
|---|---|---|
| THE HAGUE | 17 March 1998 | Pelsers, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)